# EUROPÄISCHE PATENTSCHRIFT

(11) **EP 0 602 258 B1**
(45) Veröffentlichungstag und Bekanntmachung des Hinweises auf die Patenterteilung: **09.04.1997**
(21) Anmeldenummer: 92121227.0
(22) Anmeldetag: 14.12.1992
(51) Int. Cl.: H05K 1/00, H05K 3/46, H05K 1/02, H05K 3/00

(54) **Leiterplatten mit lokal erhöhter Verdrahtungsdichte und konischen Bohrungen sowie Herstellungsverfahren für solche Leiterplatten**
Printed circuit with local higher wiring density and conical via holes and method of manufacturing such printed circuits
Circuits imprimés avec densité de câblage localement plus élevée et trous de connexion coniques, ainsi que leur méthode de fabrication

(43) Veröffentlichungstag der Anmeldung: 22.06.1994
(73) Patentinhaber: International Business Machines Corporation, Armonk, N.Y. 10504 (US)
(72) Erfinder: Arnold, Hans, W-7033 Herrenberg/Gültstein (DE); Bohlen, Harald, Dipl.-Phys., W-7403 Ammerbuch 5 (DE); Lück, Peter, Dipl.-Ing., W-7250 Leonberg (DE); Tam, Andrew C. Dr., Saratoga, California (US); Wagner, Hans Helmut, Dipl.-Phys. Dr., W-7031 Altdorf (DE); Zapka, Werner, Dipl.-Phys. Dr., W-7034 Gärtringen (DE); Ziemlich, Winfrid, Dipl.-Phys, W-7034 Gärtringen (DE)
(74) Vertreter: Rach, Werner, Dr.

(56) Entgegenhaltungen:
- EP-A- 0 478 313
- EP-A- 0 498 258
- DE-A- 4 021 965
- US-A- 4 830 691
- PATENT ABSTRACTS OF JAPAN, Bd. 16, Nr. 212 (M-1250) 19. Mai 1992 & JP-A-40 37 494

## Beschreibung

Die vorliegende Erfindung betrifft Leiterplatten und ein Verfahren zum Herstellen von Leiterplatten. Sie betrifft außerdem ein Registrationssystem für die Herstellung von Leiterplatten.

Mit der dramatisch ansteigenden Integrationsdichte moderner Halbleiterbausteine wie z.B. Mikroprozessoren oder Logikchips geht zwingend eine Erhöhung der Anzahl und der Dichte der Anschlussterminals (I/O) der Chips einher. Es sind bereits Module bekannt, die Chips mit mehr als 400 Anschlüssen aufnehmen können. Allerdings ist die Grundfläche solcher Bauelemente deutlich größer als bei bisherigen Komponenten. Die Anforderungen an kritische Signalverzögerungszeiten innerhalb der Datenverarbeitungssysteme erfordern aber in steigendem Maße kleiner werdende Minimalabstände zwischen kritischen Chips.

Man kann diesen Forderungen dadurch gerecht werden, daß man mehrere Chips in aufwendigen Multi-Chip-Modulen unterbringt und damit die Abstände zwischen kritischen Chips extrem klein macht.

Idealer wäre es allerdings, die Chips direkt auf die Leiterplatte aufzulöten (Direct Chip Attach, DCA), da hierbei eine gesamte Packaging-Ebene wegfallen würde und folglich neben verringerten Signalverzögerungen erhebliche Kosteneinsparungen erzielbar wären. In diesem Fall müssten allerdings die Leiterzugbreiten und -abstände sowie die entsprechenden Bohrungen in Chipnähe erheblich kleiner sein als dies mit konventioneller Leiterplattentechnik machbar ist. Siehe US-A-4 830 691 und DE-A-4 021 965.

Eine ganze Reihe von Vorschlägen sind zur Lösung dieses Problems gemacht worden, so zum Beispiel der sogenannte SLC (Surface laminar circuit)-Prozess, bei dem über zwei Dünnfilmlagen auf der Oberfläche einer konventionellen Leiterplatte Chips direkt auf die Kontakte der Platine aufgelötet werden können. Dieser Fertigungsprozess ist relativ komplex und erfordert aufwendige Registrier- und Glättungsverfahren.

Bei der Anwendung konventioneller Leiterplattentechniken lassen sich die Bohrungen (> 100 µm) noch mechanisch bohren. Sollen jedoch DCA-Techniken angewendet werden, die Bohrungen < 50 µm erfordern, ist ein mechanisches Bohren nicht mehr möglich, da die Bohrer den Belastungen nicht mehr standhalten und abbrechen können. Zudem führt die Anwendung mechanischer Bohrtechniken zu Bohrungenn mit steilen vertikalen Seitenwänden und einer scharfen Seitenkontur auf der Probenoberfläche. Beide Effekte beeinflussen die sich anschließende galvanische Metallabscheidung negativ, da bspw. durch eine erhöhte lokale Abscheidungsrate unerwünscht dicke Metallringe rund um die Bohrungen entstehen.

In den Feinstleiterbereichen, d.h., in Bereichen mit hohen Anforderungen bzgl. der I/O-Dichte, müssen aufgrund der Verringerung der Durchmesser für die Bohrungen in diesen Bereichen sehr hohe Anforderungen an die Positioniergenauigkeit des entsprechenden Registrationssystems gestellt werden, so daß bspw. bei der Metallstrukturierung in den Bohrungen das Metall an der exakt genauen Position verbleibt. Die bisher bekannten mechanischen Positionier- und Registrierungssysteme sind auf diese Feinstregistrierungen nicht mehr anwendbar. Des weiteren können einige prozessimmanente Fehlerqellen, die bei den bisherigen Systemen im Verlauf des Registrationsprozesses "mitgeschleppt" wurden, bei solch kritischen Positionieraufgaben nicht mehr toleriert werden.

Aufgabe der vorliegenden Erfindung ist es somit, ein kostengünstig durchführbares Verfahren zum Herstellen von Leiterplatten, die über eine für das direkte Aufbringen von Bauelementen ausreichende Verdrahtungskapazität verfügen, zur Verfügung zu stellen, wobei die oben geschilderten Nachteile bzgl. der Metallstruktur in den Bohrungenn vermieden werden können.

Eine weitere Aufgabe der Erfindung ist es, ein leistungsfähiges Registrationssystem zur Verfügung zu stellen, das es gestattet, den hohen Anforderungen bzgl. der Herstellung von Bohrungen mit sehr geringem Lochdurchmesser gerecht zu werden.

Diese Aufgaben werden durch das erfindungsgemäße Verfahren nach Anspruch 1 gelöst.

In den Unteransprüchen sind weitere Ausgestaltungen des erfindungsgemäßen Verfahrens dargestellt.

Das erfindungsgemäße Verfahren ermöglicht es, in den Teilbereichen der Leiterplatte, in denen Halbleiterbausteine direkt aufgebracht werden, d.h., in Bereichen mit sehr hohen Anforderungen bezüglich der I/O-Dichte, eine sehr hohe Verdrahtungsdichte zur Verfügung zu stellen und gleichzeitig durch die Herstellung der Bohrungen mittels Laser-Ablation-Technik mit einer speziellen Lasermaske eine bessere Verteilung der Belegung mit abgeschiedenem Metall in den Bohrungen zu erzielen. Die kritischen Prozeßschritte müssen nur an wenigen Positionen der Leiterplatte durchgeführt werden.

Desweiteren können auf diese Weise Schwierigkeiten mit Planaritätsanforderungen im DCA-Chip-Bereich vermieden werden.

So lassen sich bspw. kostengünstig PIH (Pin-in-hole)-bzw. SMT (surface mount technology)-Komponenten und Chips gleichzeitig auf einer Karte plazieren.

Durch eine geeignete optische Registrierung, vorzugsweise im Zusammenhang mit einer computerunterstützten Auswertung der entsprechenden Informationen, kann außerdem eine sehr genaue Registrierung bzw. Positionierung während der entsprechenden Verfahrensschritte erreicht werden. Durch die Schaffung einer mit dem Prozeß in unmittelbarem Zusammenhang stehenden Registration wird eine optimierte Lösung in Abhängigkeit von Vorfehlern oder Nutzung von Toleranzen erhalten. Die Entkopplung von Nachfolgeprozessen kann von bisher bekannten Systemen nicht ausreichend berücksichtigt werden und vermindert die Gutteilausbeute der Produktion beträchtlich. Durch die erfindungsgemäße Lösung erreicht man eine Entkopplung mit optimierter Zuordnung der Registration zum nächstfolgenden Fertigungsblock und dessen prozeßabhängiger Registration.

Im folgenden wird das erfindungsgemäße Verfahren anhand der Zeichnungen näher erläutert.

Es zeigt
- Fig. 1: eine schematische Darstellung der erfindungsgemäßen Verfahrensschritte,
- Fig. 2: die durch Variierung des Laserstrahlungsflusses erzielbaren unterschiedlichen Seitenwandneigungen in den Bohrungen,
- Fig. 3: eine schematische Darstellung des Laser-Ablation-Prozesses gemäß der vorliegenden Erfindung zur Durchführung des erfindungsgemäßen Verfahrens,
- Fig. 4: schematisch eine Ausgestaltung einer erfindungsgemäßen Lasermaske zur Durchführung des erfindungsgemäßen Verfahrens,
- Fig. 5A: das Prinzip der optischen Registrierung zweier Ebenen zueinander,
- Fig. 5B: das Prinzip der optischen Registrierung von internen Lagen beim Photoprozeß, und
- Fig. 5C: das Prinzip der optischen Registrierung externer Lagen beim Photoprozeß

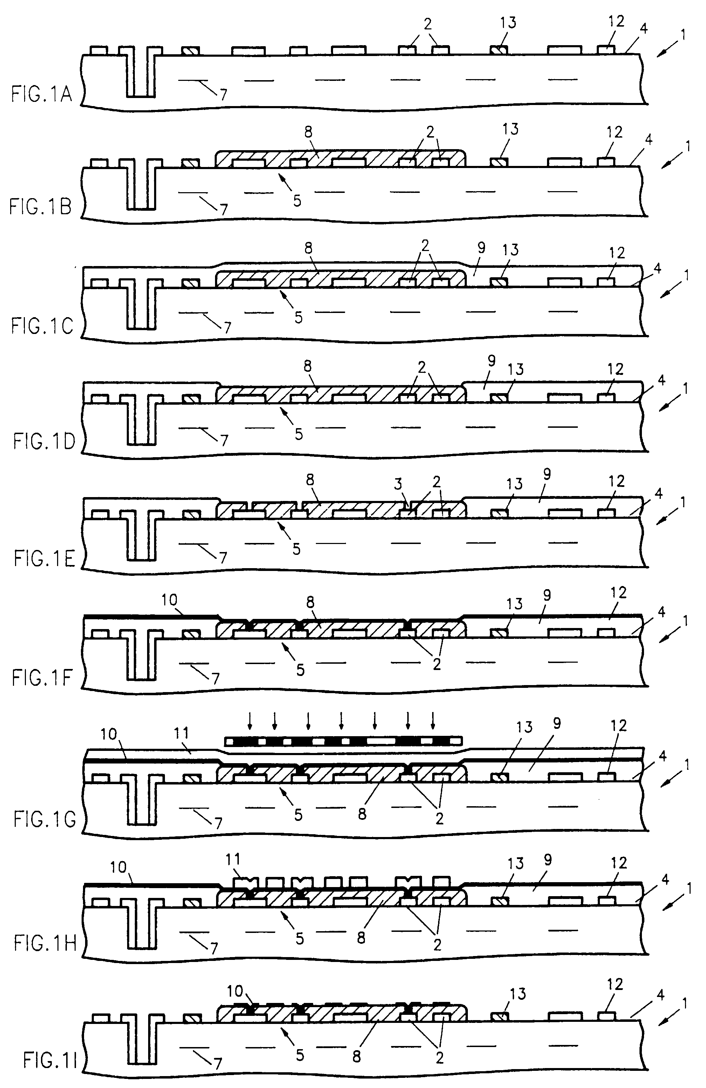

Wie aus Fig. 1 ersichtlich, wird zunächst die Leiterplatte 1 mit den Innenlagen 7 einschließlich beider strukturierter Außenlagen, d.h., einschließlich der aus einem leitenden Material bestehenden Leiterzüge 2 fertiggestellt. Hierzu werden in der Leiterplattentechnologie allgemein bekannte Herstellungsverfahren angewandt. Die Verdrahtungsdichte der Leiterzüge 2 entspricht dabei der eines ersten Bereichs 4, d.h., sie beträgt mehr als ca. 5 cm/cm², vorzugsweise ca. 10 cm/cm² (Fig. 1A). Anschliessend wird an den für den späteren DCA-Prozess vorgesehenen Positionen, d.h., in einem Teilbereich 5 der Leiterplatte 1 eine dünne Schicht eines geeigneten Dielektrikums 8 auf der Oberfläche der Leiterplatte aufgebracht. Dies kann z.B. mittels einer Vakuum-Laminierpresse geschehen. Als Dielektrikum kann jedes Polymermaterial mit einer Dielektrizitätskonstanten im Bereich von etwa 2,5 bis etwa 3,5 verwendet werden. Vorzugsweise wird jedoch reines oder verstärktes Polyimid verwendet. Die Dicke der Folie wird je nach der elektrischen Konfiguration (Impedanz, Leiterzugabstand) ausgewählt (Fig. 1B). Sie beträgt vorzugsweise zwischen 25 und 50 µm.

Im nächsten Schritt wird dann die gesamte Oberfläche der Leiterplatte 1 mit einem ersten Photoresist 9 beschichtet, in bekannter Weise belichtet und der vorher laminierte Teilbereich 5 durch Entwickeln des Photoresist freigelegt (Fig. 1C, 1D).

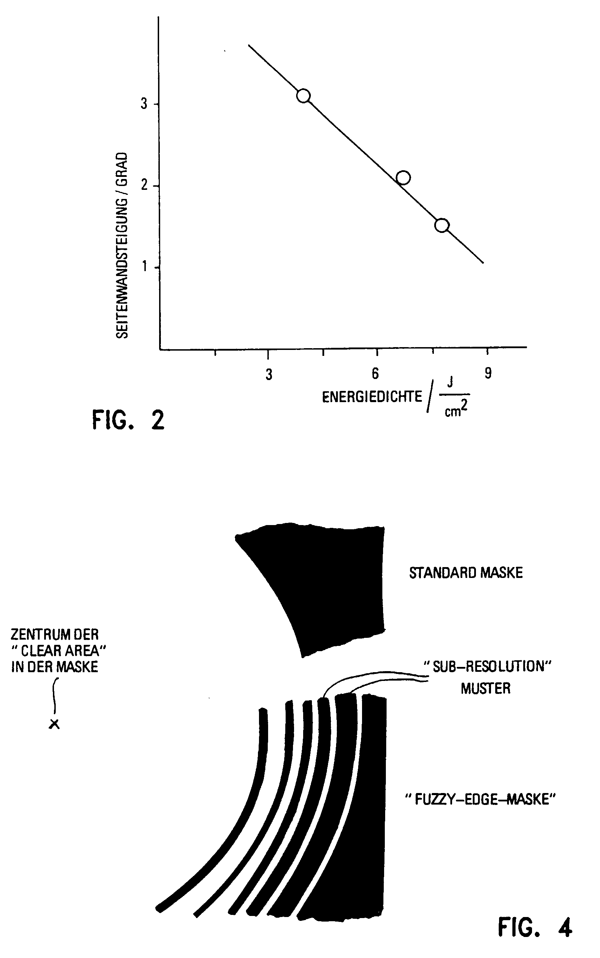

Anschließend werden Bohrungen 3 zu den Leiterzügen 2 durch das Dielektrikum 8 im Teilbereich 5 eingebracht. Diese Bohrungen werden mit einem geeigneten Laser-Verfahren, bspw. mit Hilfe eines UV-Excimer-Lasers gebohrt, der es erlaubt, Verbindungslöcher mit sehr kleinem Durchmesser (< 100 µm, vorzugsweise < 50 µm) einzubringen (Fig. 1E). Die Herstellung der Bohrungen durch Laser-Ablation erlaubt die Herstellung von variablen Seitenwandneigungen durch die Veränderung des Laserstrahlungsflusses (Energiedichte) während des Bohrens. So können bspw. nahezu senkrechte Seitenwände (89°) und scharfe Seitenkonturen durch sehr hohe Energiedichten erreicht werden, während andererseits weniger steile Neigungen bei geringeren Energiedichten erzielt werden können (Fig. 2). Die für eine galvanische Metallabscheidung bestgeeignetsten flachen Seitenwandprofile der Bohrungen, d.h., solche Bohrungen, die eine nach unten zulaufende konische Form aufweisen, werden also mit einem niedrigen Laserstrahlungsfluss erreicht, wohingegen unter Berücksichtigung des beim Bohren der Durchgangs- oder auch Sacklöcher erforderlichen Durchsatzes hohe Laserstrahlungsflüsse erforderlich sind. Da diese einander entgegenstehenden Erfordernisse mit bei herkömmlichen Verfahren des Laserbohrens verwendeten Masken nicht gelöst werden können, wird erfindungsgemäß vorgeschlagen, eine Lasermaske zu verwenden, die es erlaubt, die gewünschten Seitenwandprofile der Bohrungen mit einer vorgegebenen, konstant hohen Laserleistung zu erzielen.

Die grundlegende Idee besteht dabei darin, die Transmission der Maske innerhalb der "clear areas" so auszulegen, daß die resultierende Strahlungsintensitätsverteilung auf der Probe Bohrungen mit dem gewünschten Kantenprofil erzeugt ("Fuzzy-Edge-Maske").

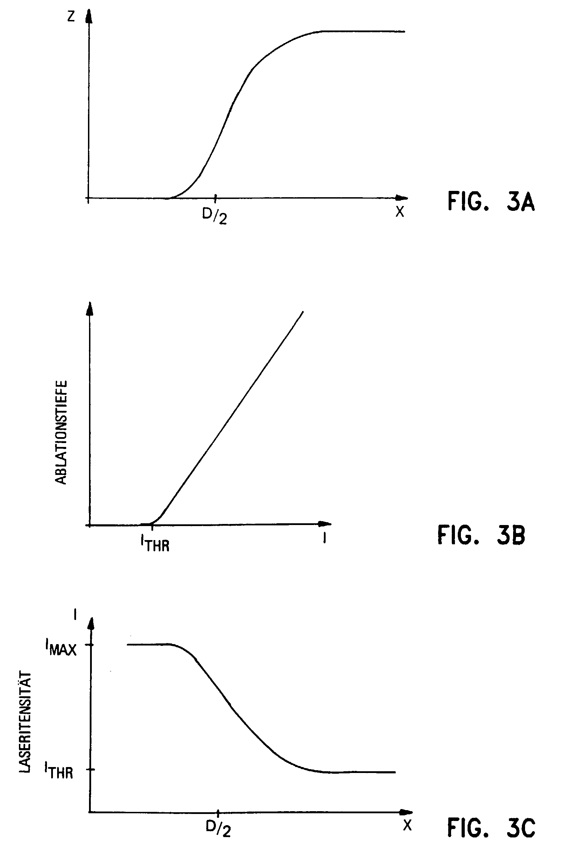

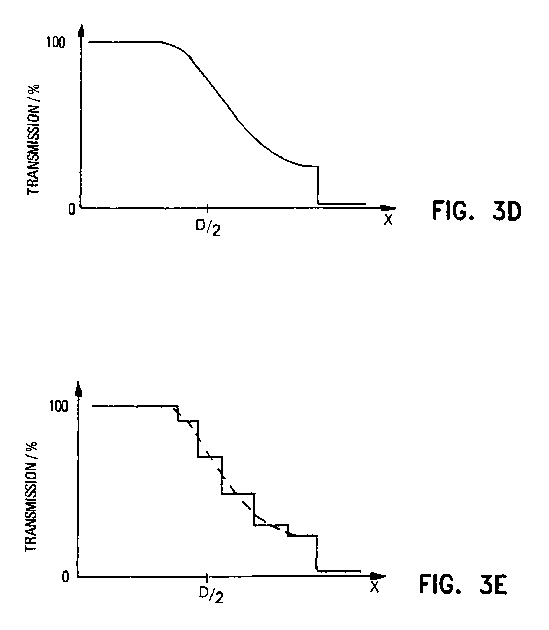

Wird bspw. ein Bohrlochprofil angestrebt, wie es in Fig. 3a dargestellt ist, so kann das durch einen Laser-Ablation-Prozess erreicht werden, der die in Fig. 3b dargestellt ist und die in Fig. 3c gezeigte Laser-Intensitätsverteilung aufweist. (I_{THR} bezeichnet dabei den Schwellenwert der Intensitätsdichte der Laserstrahlung, oberhalb dessen eine Ablation des betreffenden Materials eintritt und D/2 stellt die eine Kante einer kreisförmigen Struktur (Bohrung) mit Durchmesser D dar.) Eine solche Intensitätsverteilung kann durch eine Maske erreicht werden, deren Transmissionsverlauf in Fig. 3d dargestellt ist. Da jedoch die direkte Herstellung von Masken mit einer solchen, sich kontinuierlich ändernden Transmission schwierig ist, wird erfindungsgemäß vorgeschlagen, eine Maske zu verwenden, die eine stufenweise lokale Änderung der Transmission aufweist. Wie aus Fig. 3e zu entnehmen ist, nähert sich eine solche stufenförmige Kurve stark der gewünschten Form (in Fig. 3e gestrichelt dargestellt) an.

Für das erfindungsgemäße Verfahren können sogar standardisierte "Digital"-Masken (klar/opak) verwendet werden, wenn die lokale optische Transmission der entsprechenden Masken durch die Einführung von Maskenformteilen variiert wird, die größenordnungsmäßig unterhalb der Auflösungsgrenze der Projektionsoptik liegen. Auf diese Weise wird das projizierte Bild auf der Probenoberfläche "verschmiert", was in einer ungefähren Strahlungsintensität resultiert, die durch die lokale Dichte der Subauflösungsmuster der Maske bestimmt wird.

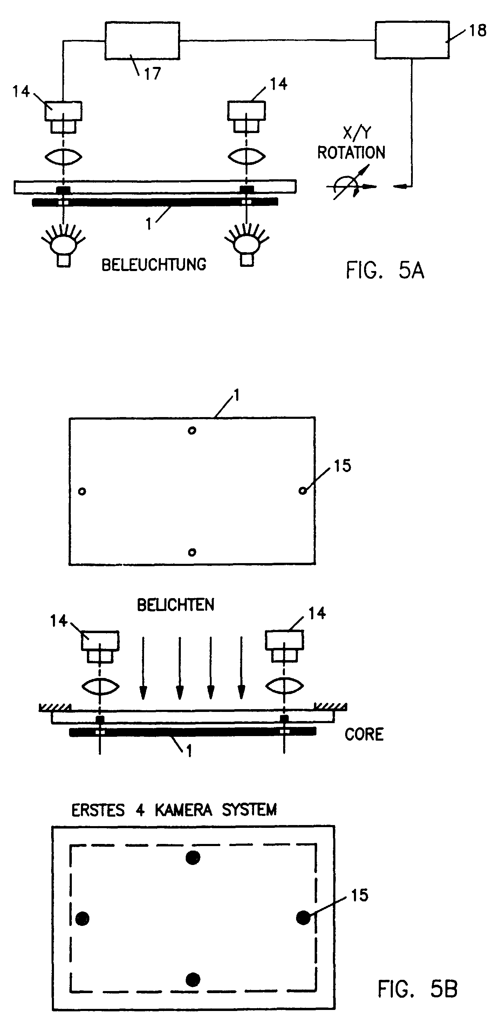

Fig. 4 zeigt eine mögliche Ausgestaltung einer solchen "Fuzzy-Edge-Maske" für das Bohren von runden Bohrungenn mit glatten Rändern im Vergleich mit einer Standard-Maske. Selbstverständlich ist eine solche Maske in ihrer Anwendung nicht auf das Bohren von Bohrungenn beschränkt. So können z.B. auf diese Weise auch Sacklöcher etc. hergestellt werden. Während die Standard-Maske einen klar definierten "Clear"-Durchmesser aufweist, besitzt die "Fuzzy-Edge-Maske" sowohl "clear" als auch opake Ringformen, die grössenordnungsmässig so gewählt werden können, daß sie ein gewünschtes Profil ergeben.

Die Breiten der zusätzlichen Ringstrukturen bei einem angenommenen Lochdurchmesser werden dabei so gewählt, daß sie unterhalb der Auflösungsgrenze der Projektionsoptik liegen. So ist z.B. bei Bohrungen in der Größenordnung von 50 µm 5 µm ein akzeptabler Wert für diese Breiten der zusätzlichen Markenformteile. Die Parameter des optischen Systems, wie numerische Apertur und Wellenlänge, können entsprechend bestimmt werden, um diese Auflösungsgrenze zu definieren. Im Gegensatz zu bekannten Defokussierungstechniken ist es also mit einer solchen "Fuzzy-Edge-Maske" möglich, verschiedene Seitenwandprofile, wenn gewünscht, in verschiedenen xy-Richtungen mit hohen Laserflussdichten herzustellen. Auf diese Weise gelingt es, einerseits eine hohe Qualität (durch entsprechende Seitenwandprofile) und andererseits einen grossen Durchsatz (durch hohe Laserleistung) beim Excimer-Laser-Bohren von Durchgangs- oder auch Sacklöchern miteinander zu verbinden.

Selbstverständlich erfordert das Bohren solcher Löcher mit geringem Durchmesser eine besonders genaue Positionierung der Leiterplatte. Eine solche Registrierungsroutine, die eine exakte Justierung der Leiterplatten erlaubt, wird weiter unten beschrieben.

Nachdem nun die Bohrungen mit den gewünschten Seitenwandprofilen in die Leiterplatte eingebracht worden sind, wird diese nun in der Weise weiterverarbeitet, daß, nach einer geeigneten Vorbehandlung, bspw. das Aufbringen eines Pd-seed-layers, galvanisch eine relativ dünne Kupferschicht ganzflächig auf die Leiterplatte, insbesondere jedoch auf den Teilbereich 5, d.h., an den für den späteren DCA-Prozess vorgesehenen Positionen, abgeschieden wird (Fig. 1F). Das Aufbringen dieser Kupferschicht kann bspw. über ein Direct-Plating-Verfahren erfolgen.

Dann wird die gesamte Leiterplatte 1, insbesondere aber der Teilbereich 5 mit einem zweiten Photoresist 11 beschichtet, wobei es sich bei dem Resist bevorzugt um eine auflaminierte Photolackfolie handelt, aber auch ein Flüssigresist angewandt werden kann. Der aufgebrachte Photoresist wird musterförmig, bspw. mit Hilfe einer Photomaske, belichtet, wobei diese Belichtung wiederum insbesondere in dem Teilbereich 5 erfolgt, und anschließend entwickelt (Fig. 1G, 1H). Die Belichtung erfolgt für jede DCA-Position einzeln, dabei wird vorzugsweise die in der Halbleitertechnologie seit langem bekannte Stepper-Technik angewendet.

Im letzten Schritt wird dann die Metallschicht 10 an den Stellen, wo sie nicht von Photoresist 11 bedeckt ist, entfernt, was z.B. durch Kupferätzen erreicht werden kann. Schliesslich werden beide Photoresistlagen 9 und 11 entfernt. Die Leiterzüge im Teilbereich 5 sind jetzt strukturiert und mit der darunter liegenden Kupferebene verbunden. Die Verdrahtungsdichte in dem Teilbereich 5 ist dabei etwa um den Faktor 4 höher als in dem ersten Bereich 4, d.h., sie beträgt mehr als ca. 20 cm/cm², bevorzugt ca. 40 cm/cm² (Fig. 1I).

Die nachfolgenden Prozeßschritte, wie z.B. das Aufbringen einer Lötstopmaske, entsprechen dem konventionellen Ablauf bei der Leiterplattenherstellung.

Für die Registrierung der in Schritt c.) zu belichtenden Bereiche sind in den Randbereichen der Leiterplatte 1 globale Registrationsmarken 12, bspw. in Form von runden oder rechteckigen Marken, aufgebracht. Bisher wurden ausschließlich mechanische Registrierverfahren benutzt, deren systembedingte Toleranzen Positionierfehler bis zum Ende des Prozesses akkumulierten, da ein Referenzsystem bei jedem Prozeßschritt wiederverwendet wurde und dieses System degradierte. Eine mechanische Registrierung reicht allerdings im vorliegenden Fall nicht aus. Die Bereiche hoher Verdrahtungsdichte und somit enger Toleranzen erfordern für die Registrierung optisch aufzunehmende lokale Registrationsmarken 13, da Registriergenauigkeiten im Bereich von wenigen µm gefordert sind.

Die Registrierung über die Marken 13 erfolgt nach der vorliegenden Erfindung vorzugsweise mittels optischer Kameraregistration. Schon ein optisches Registriersystem läßt sich durch seine sehr genaue Herstellungs- und Vermessungsmöglichkeit gut für eine automatische Positionierung verwenden, während bisher bekannte mechanische Aufnahmelöcher Form und Lage im Prozeßverlauf ändern. Durch die Verwendung zweier voneinander entkoppelter Registrierreferenzen kann die Gesamtregistrierung jedoch noch erheblich verbessert werden.

Erfindungsgemäß wird dazu ein hochpräzises Registrationssystem vorgeschlagen, das eine Folgeprozeßkopplung mit fertigungsgerechter Ausnutzung der Fertigungstoleranzen und eine gleichzeitige Entkopplung von Nachfolgeprozessen aufweist, bei denen die Vorläuferprozesse zwar eine direkte Abhängigkeit zur Lage der Vorprozesse haben sollen, jedoch eine weitere Toleranzaddition der Prozeßfolgeschritte nicht mehr zulassen.

Es werden dabei bevorzugt mindestens zwei Referenzsysteme erzeugt und ihre genaue Lage auf der Leiterplatte mit Hilfe zweier optischer, voneinander unabhängiger Kamerasysteme, die bevorzugt aus jeweils 4 Kameras bestehen, zur mikrometergenauen Positionierung von Zwischenprodukten in kritischen Fertigungsmaschinen benutzt. Zusätzlich kann noch ein computergestütztes Auswertesystem zur Auswertung der entsprechenden Informationen und Weiterverwendung dieser Informationen zur weiteren Positionierung der Leiterplatte verwendet werden.

Die erfindungsgemäße Registrierungsroutine ist selbstverständlich nicht auf die Herstellung von gedruckten Leiterplatten beschränkt, sondern kann bei allen Stückguterstellungen angewendet werden, die eine Registration zu Vorläuferprozessen erfordern, fertigungstechnisch gekoppelt sind, eine sehr hohe Positionier- bzw. Registrierungsgenauigkeit erfordern und die Entkopplung von Prozessen zulassen, so z.B. in der Image-Verarbeitung.

Im folgenden wird die erfindungsgemäße Registrierungsroutine an der Herstellung von Leiterplatten nach dem vorstehend beschriebenen Verfahren näher erläutert.

Zunächst wird das Grundmaterial der Leiterplatte 1 im konventionellen Prozeß erstellt und auf Fertigungsformat zugeschnitten. Dabei wird bei sogenannten "buried vias" das Core gebohrt und erhält gleichzeitig die für die Registration erforderlichen 4 Positionsmarken. Bei Teilen, die keine buried vias aufweisen, werden nur die Registrationslöcher eingebracht.

Der nachfolgende Verkupferungsprozeß ist registrationsunabhängig und somit neutral.

Der erste Photoprozeß hat eine direkte Abhängigkeit zum Bohrprozeß und ist deshalb in bezug auf die Registration gekoppelt. Die Registration erfolgt hier über ein erstes von zwei voneinander unabhängigen 4-Kamerasystemen 14, das optisch die Leiterplatte registriert und mit Hilfe eines zusätzlichen computergestützten Positionsbestimmungssytems, das aus einer Bildauswerteeinheit 17 und einer damit verbundenen Motorsteuerung 18 besteht, die Lage genau berechnet, indem die Abweichung der Kameraposition vom Idealwert direkt als Parameter in die Motorsteuerung eingeht (Fig. 5 A, B).

Der nachfolgende konventionelle Belichtungsschritt arbeitet bevorzugt mit einer Belichtungsmaschine, die ebenfalls mit einem 4-Kamerasystem ausgerüstet ist. Eine bevorzugte Ausführungsform sieht jedoch eine Kombination zweier unabhängiger 4-Kamerasysteme vor, um kostenintensive Einrichtungen zu vermeiden.

Glassmaster und Produkt (Core/Composite) werden zunächst mittels einer Ladetransporteinrichtung zu einem Belichtungstisch überführt. Das Glassmaster wird dabei zu einem auf diesem Belichtungstisch angeordneten Rahmen transportiert, mit Hilfe des 4-Kamerasystems 14 positioniert und in dieser Position entweder mechanisch oder durch Vakuum festgehalten. Dann wird das Produkt in seine Position gebracht, automatisch mit Hilfe des zweiten, unabhängigien 4-Kamerasystems (nicht gezeigt) in bezug auf das Glassmaster registriert und belichtet. Dabei werden die DCA-Positionen zunächst durch sogenannte "Black Layer" abgedeckt, um eine Belichtung dieser Bereiche im ersten Schritt zu verhindern.

Mehrere durch den oben beschriebenen Ablauf hergestellte Cores (Signal/Signal-oder Power/Power-Cores) bilden den Grundstock für die gedruckte Schaltung. Um mehrere dieser Cores zueinander in Referenz zu bringen, wird nun eine Positioniereinheit genutzt, die das gleiche 4-Kamerasystem aufweist, wie es für die vorher beschriebene Belichtung verwendet wird.

Der in diesem Schritt registrierte Teilestapel wird nun in herkömmlicher Weise laminiert und zugeschnitten. Alle Fehler und die Nutzung von Produkttoleranzen dieses Teils liegen jetzt irreversibel fest und können nicht mehr beeinflußt werden. Im Gegensatz dazu gestatten es bisher bekannte Registrierungssysteme (bspw. mittels Röntgenstrahlen) nur, eine Fehlerfrüherkennung durchzuführen bzw. eine optimierte Weiterverarbeitung zu ermöglichen. Selbstverständlich ist dies auch bei dem erfindungsgemäßen Registrierungssytem möglich.

Im folgenden Bohrschritt wird die Registrierung mit Hilfe des gleichen 4-Kamerasystems durchgeführt, wie es für die Aufnahme des Teiles verwendet wurde. Der Bohrprozeß weist zwar eine Kopplung zum internen Leiterzugmuster auf, da zu seiner Registrierung lokale Positionsmarkierungen 13 verwendet werden, die zur selben Zeit auf das Produkt gebracht wurden, wie die äußeren Leiterzugebenen. Eine Prozeßkopplung ist jedoch nur zum äußeren Bohrprozeß gegeben.

Der sich anschließende Prozeßschritt des Verkupferns der Durchkontaktierungen ist wiederum von der Registration unabhängig.

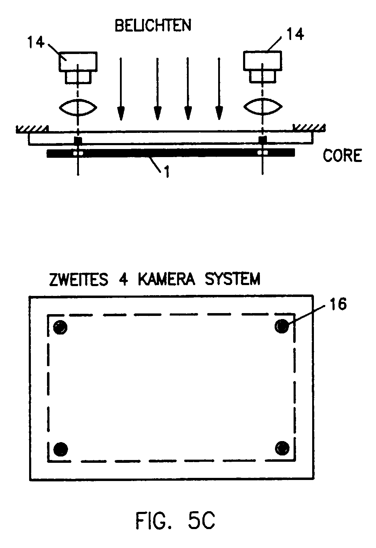

Als nächster Schritt folgt ein zweiter Photoprozeß, der, wie oben bereits angedeutet, direkt gekoppelt ist, und einer Referenz 16 bedarf, die aus dem vorherigen Bohrprozeß stammen muß. Diese Referenz wird aber mit der Erstellung des Leiterzugmusters erbracht und liegt damit auf der zweiten 4-Kameraposition (Fig. 5 C). Auf diese Weise wird der erste Fertigungsteil vom zweiten entkoppelt und die gekoppelten Folgeprozesse können auf einem neuen Toleranzfeld aufbauen.

Durch einen weiteren Photoprozeß wird dann die äußere Schaltung erstellt. Anschließend wird ein Funktionstest durchgeführt, der mit Hilfe eines computergestützten Videokamera-Auswertesystems vorgenommen werden kann. Hierbei können eventuelle Fehler erkannt und eine erforderliche Reparatur ermöglicht werden.

Um die gedruckte Schaltung ihrer Endmontage zuzuführen, sind noch weitere Prozesse mit hoher Genauigkeit erforderlich, die eine Kopplung zum externen Photoprozeß haben. So wird bspw., um eine Lötstopmaske zu erstellen, ein Schutzlack aufgebracht, der für heutige Anforderungen bevorzugt photosensitiv ist. Diese Lötstop-/Schutzschicht kann wiederum mit einer Photomaschine aufgebracht werden und muß das Leiterzugmuster optimal eingrenzen, was wiederum mit dem 4-Kamerasystem und der im Bohrprozeß eingebrachten Referenz mit einem Photoprozeß geschieht. Das Aufbringen der Lötpaste erfolgt wie beim Photoprozeß ebenfalls mit einem 4-Kamerasystem, um die Paste in geeigneter Menge in die exakt bestimmte Lage zu bringen.

Mit der vorstehend geschilderten Arbeitsweise, nämlich der Kopplung der aufeinander einwirkenden Prozesse bzw. der Entkopplung begrenzter Teilabschnitte des Prozesses, die schon Fehlerquellen und Toleranznutzung des Vorprozesses beinhalten, gelingt es, Fine-line-Strukturen, d.h., Strukturen mit sehr hohen Anforderungen bzgl. der I/O- Dichte, die für die Anwendung der DCA-Methode notwendig sind, wesentlich einfacher herzustellen.

## Patentansprüche

1. Verfahren zum Herstellen von Leiterplatten (1) mit Leiterzügen (2) aus einem leitenden Material und mit mit einem leitenden Material beschichteten Bohrungen (3), die zur vertikalen Verbindung der Leiterzüge (2) dienen, wobei auf einer Oberfläche der Leiterplatte ein erster Bereich (4) mit einer ersten Verdrahtungsdichte und ein zweiter Bereich (5), der einen Teilbereich des ersten Bereichs (4) darstellt und der eine wesentlich höhere Verdrahtungsdichte als der erste Bereich (4) aufweist, vorliegen, und wobei die Bohrungen (3) in dem Teilbereich (5) eine nach unten zulaufende konische Form aufweisen mit folgenden Prozeßschritten:
a.) Herstellen einer Leiterplatte 1 mit Innenlagen (7) und äußeren Leiterzügen (2), deren Verdrahtungsdichte der des ersten Bereichs (4) entspricht;
b.) Aufbringen eines Dielektrikums (8) auf einem Teilbereich (5) der Oberfläche der Leiterplatte (1);
c.) Beschichten der gesamten Leiterplatte mit einem ersten Photoresist (9), Belichten des Photoresist und nach dem Entwickeln Entfernen des Photoresist von dem Teilbereich (5);
d.) Einbringen von Bohrungen (3) durch das Dielektrikum (8) zu den Leiterzügen (2) in dem Teilbereich (5);
e.) Aufbringen einer Metallschicht (10) auf die gesamte Leiterplatte (1), insbesondere auf den Teilbereich (5);
f.) Beschichten der gesamten Leiterplatte, insbesondere des Teilbereichs (5), mit einem zweiten Photoresist (11), musterförmiges Belichten des Photoresists, insbesondere im Teilbereich (5), und Entwickeln des Photoresists;
g.) Entfernen der Metallschicht (10), wo diese nicht von Photoresist (11) bedeckt ist, und Entfernen des ersten und des zweiten Photoresists (9) und (11);
dadurch gekennzeichnet, daß die Bohrungen (3) in dem Teilbereich (5) zu den Leiterzügen (2) mittels eines Lasers eingebracht werden, wobei die konische Form durch eine Verminderung der Energiedichte des Lasers erzeugt wird.

2. Verfahren nach Anspruch 1, dadurch gekennzeichnet, daß die Verminderung der Energiedichte durch eine Lasermaske erreicht wird, die eine sich im wesentlichen kontinuierlich ändernde optische Transmission aufweist.

3. Verfahren nach einem der Ansprüche 1 oder 2, dadurch gekennzeichnet, daß für die Registrierung der in Schritt c.) zu belichtenden Bereiche globale Registrationsmarken (12) auf der Leiterplatte (1) vorhanden sind, die in Schritt a.) generiert wurden.

4. Verfahren nach einem der Ansprüche 1 oder 2, dadurch gekennzeichnet, daß in den Schritten d.) bis g.), soweit nur der Teilbereich (5) bearbeitet wird, die Registration über lokale Registrationsmarken (13) erfolgt.

5. Verfahren nach Anspruch 3 oder 4, dadurch gekennzeichnet, daß sowohl die Registration über die auf der Leiterplatte vorhandenen globalen Registrationsmarken (12) als auch die Registration über die lokalen Registrationsmarken (13) mittels optischer Kameraregistration erfolgt.

6. Verfahren gemäßs Anspruch 5, dadurch gekennzeichnet, daß für die Durchführung der optischen Kameraregistration zwei voneinander unabhängige 4-Kamera-Systeme verwendet werden.

7. Verfahren nach Anspruch 8, dadurch gekennzeichnet, daß zusätzlich zu den unabhängigen 4-Kamera-Systemen ein computergestütztes Positionsbestimmungssystem sowie ein Videokamera-Auswertesystem verwendet wird.

## Claims

1. Method for the manufacture of printed circuit boards (1) with conductors (2) of a conducting material and with apertures (3) coated with a conducting material which serve for the vertical connection of the conductors (2), provided, on one surface of the printed circuit board, with a first region (4) with a first wiring density and a second region (5), representing a sub-region of the first region (4) and having a substantially higher wiring density than the first region (4) and where the apertures (3) in the sub-region (5) exhibit a downwardly conical form, said manufacturing method having the following steps:
a.) manufacturing a printed circuit board 1 with an inner layer (7) and external conductors (2), the wiring density of which corresponds to the first region (4);
b.) applying a dielectric (8) to a sub-region (5) of the surface of the printed circuit board (1);
c.) coating the whole of the printed circuit board with a first photo-resist (9), exposing the photo-resist and, after development, removing the photo-resist from the sub-region (5);
d.) Effecting apertures (3) through the dielectric (8) to the conductors (2) in the sub-region (5);
e.) Applying a metal layer (10) over the whole of the printed circuit board (1), in particular over the sub-region (5);
f.) Coating the whole of the printed circuit board, in particular, the sub-region (5), with a second photo-resist (11), exposing the photo-resist through a pattern, particularly in the sub-region (5) and developing the photo-resist;
g.) Removing the metal layer (10) where it is not covered by the photo-resist and removing the first and second photo-resists (9) and (11);
characterised in that the apertures (3) in the sub-region (5) are brought to the conductors (2) by means of a laser, where the conical form is produced by reducing the energy density of the laser.

2. Method as in Claim 1, characterised in that the reduction in energy density is effected by means of a laser mask having essentially a continuously varying optical transmission.

3. Method as in one of the Claims 1 or 2, characterised in that, to effect registration of the areas to be exposed in step c.), there are global registration marks (12) on the printed circuit board (1), which are generated in step a.).

4. Method in accordance with one of the Claims 1 or 2, characterised in that in steps d.) to g.), where only the subregion (5) is being processed, registration is effected by means of local registration marks (13).

5. Method in accordance with Claims 3 or 4, characterised in that both the registration by means of the global registration marks (12) present on the printed circuit board and also the registration by means of local registration marks (13) are effected by means of optical camera registrations.

6. Method in accordance with Claim 5, characterised in that two independent 4-camera systems are used to carry out the optical camera registration.

7. Method as in Claim 8, characterised in that, in addition to the independent 4-camera systems, a computer controlled position-locating system and a video camera evaluation system are employed.

## Revendications

1. Procédé de fabrication de plaquettes à circuit imprimé (1), avec des chemins conducteurs (2) réalisés en un matériau conducteur et avec des perçages (3), revêtus d'un matériau conducteur et servant à assurer la liaison verticale entre les chemins conducteurs (2), sur une surface de la plaquette à circuit imprimé étant constituée une première zone (4) ayant une première densité de câblage et une deuxième zone (5), constituant une zone partielle de la première zone (4) et ayant une densité de câblage sensiblement plus élevée que celle de la première zone (4), et les perçages (3) présentant dans la zone partielle (5) une forme conique allant en s'effilant en direction du bas, avec les étapes de procédé ci-après:
a.) fabrication d'une plaquette à circuit imprimé (1) avec des couches intérieures (7) et des chemins conducteurs (2) extérieurs, dont la densité de câblage correspond à celle de la première zone (4);
b.) application d'un diélectrique (8) sur une zone partielle (5) de la surface de la plaquette à circuit imprimé (1);
c.) revêtement de l'ensemble de la plaquette à circuit imprimé par un premier photorésist (9), illumination du photorésist et, après développement, enlèvement du photorésist vis-à-vis de la zone partielle (5);
d.) ménagement de perçages (3) , à travers le diélectrique (8) vers les chemins conducteurs (2) se trouvant dans la zone partielle (5);
e.) application d'une couche métallique (10) sur l'ensemble de la plaquette à circuit imprimé (1), en particulier sur la zone partielle (5);
f.) revêtement de l'ensemble de la plaquette à circuit imprimé, en particulier de la zone partielle (5), par un deuxième photorésist (11), illumination, à la forme d'un motif, du photorésist, en particulier dans la zone partielle (5), et développement du photorésist;
g.) enlèvement de la couche métallique (10) la où celle-ci n'est pas recouverte par le photorésist (1), et enlèvement des premier et deuxième photorésists (9) et (11);
caractérisé en ce que les perçages (3) sont ménagés dans la zone partielle (5) en direction des chemins conducteurs (2), par utilisation d'un laser, la forme conique étant produite par une diminution de la densité d'énergie du laser.

2. Procédé selon la revendication 1, caractérisé en ce que la diminution de la densité d'énergie est obtenue par un masque à laser, présentant une transmission optique allant en évoluant de façon sensiblement continue.

3. Procédé selon l'une des revendications 1 ou 2, caractérisé en ce que pour la mise en coïncidence des zones à illuminer à l'étape c.) existent des marques de repérage (12), réalisées sur la plaquette à circuit imprimé (1) et ayant été générées à l'étape a.).

4. Procédé selon l'une des revendications 1 ou 2, caractérisé en ce qu'aux étapes d.) à g.), dans la mesure où l'usinage ne concerne que la zone partielle (5), le repérage s'effectue par l'intermédiaire de marques de repérage (13) locales.

5. Procédé selon la revendication 3 ou 4, caractérisé en ce que le repérage est effectué tant par l'intermédiaire de marques de repérage (12) globales existant sur la plaquette à circuit imprimé, qu'également par l'intermédiaire de marques de repérage (13) locales, par un repérage optique fait au moyen d'une caméra.

6. Procédé selon la revendication 5, caractérisé en ce qu'on utilise deux systèmes à quatre caméras, indépendants les uns des autres, pour effectuer le repérage optique par caméra.

7. Procédé selon la revendication 5, caractérisé en ce que, en plus des systèmes à quatre caméras indépendants, est utilisé un système de détermination de position, assisté par ordinateur, ainsi qu'un système d'évaluation pour caméra vidéo.
